# EUROPEAN PATENT APPLICATION

(11) **EP 4 571 523 A1**
(43) Date of publication of application: **18.06.2025**
(21) Application number: 23858886.7
(22) Date of filing: 29.06.2023
(51) Int. Cl.: G06F 13/16

(54) **MEMORY ACCESS CONTROL CIRCUIT AND MEMORY ACCESS CONTROL METHOD**

(30) Priority: 30.08.2022 CN 202211058361
(71) Applicant: Sanechips Technology Co., Ltd., Shenzhen, Guangdong 518055 (CN)
(72) Inventor: ZHANG, Long, Shenzhen, Guangdong 518055 (CN); LIU, Wufeng, Shenzhen, Guangdong 518055 (CN)
(74) Representative: Canzler & Bergmeier Patentanwälte Partnerschaft mbB
(86) International application number: PCT/CN2023/103733
(87) International publication number: WO 2024/045848

(57) **Abstract**

A memory access control circuit (100) and a memory access control method. The memory access control circuit (100) comprises: a memory-side cache circuit (10), which is used for performing parallel access on a memory according to a read instruction, and caching read parallel data into a first cache unit; and a data parallel-to-serial conversion decoding circuit (20), an input end of which is connected to an output end of the memory-side cache circuit (10), and which is used for performing parallel-to-serial conversion on the parallel data outputted by the memory-side cache circuit (10) and then performing outputting to an interface-side cache circuit.

## Description

### CROSS REFERENCE TO RELATED APPLICATIONS

The present disclosure claims the priority to Chinese Patent Application No. 202211058361.2 filed with the CNIPA on August 30, 2022, the contents of which are incorporated herein by reference in their entirety.

### TECHNICAL FIELD

The present disclosure relates to, but is not limited to, the field of design of high-performance digital chips.

### BACKGROUND

An operating frequency of a chip is an important index for measuring performance, and improving the operating frequency is an important means of improving system performance. Low-power consumption design for reducing power consumption is an important means of improving operation reliability of the chip, reducing the power consumption, and improving endurance of the chip. The network-on-chip System On Chip (SOC) architecture is mostly adopted in the field of terminal chips, communication chips or vehicle-mounted chips, the network-on-chip SOC architecture involves access of a plurality of devices to a memory, an access control circuit for the memory is an important component of SOC system design, and a memory access method and device for improving the operating frequency and reducing the power consumption are urgent problems to be solved at present.

### SUMMARY

The present disclosure provides a memory access control circuit and a memory access control method.

The present disclosure provides a memory access control circuit, including: a memory-side buffer circuit, which is configured to perform parallel access to a memory based on a read instruction, and buffer read parallel data in a first buffer unit; and a data parallel-to-serial conversion decoding circuit, which has an input terminal connected to an output terminal of the memory-side buffer circuit, and is configured to perform parallel-to-serial conversion on the parallel data output by the memory-side buffer circuit and output serial data to an interface-side buffer circuit.

The present disclosure further provides a memory access control method based on the memory access control circuit provided herein, including: by the memory-side buffer circuit, performing parallel access to the memory based on the read instruction, and buffering the read parallel data in the first buffer unit; and by the data parallel-to-serial conversion decoding circuit, performing parallel-to-serial conversion on the parallel data output by the memory-side buffer circuit, and outputting the serial data to the interface-side buffer circuit.

The present disclosure further provides a computer-readable storage medium having stored therein a computer program which, when executed by a processor, causes the processor to implement any method described herein.

The present disclosure further provides an electronic device, including a storage device and a processor, the storage device stores a computer program, and the processor is configured to run the computer program to perform any method described herein.

### BRIEF DESCRIPTION OF DRAWINGS

FIG. 1 is a block diagram of a memory access control circuit according to the present disclosure;
FIG. 2 is a flowchart illustrating a memory access control method according to the present disclosure;
FIG. 3 is a schematic diagram of a backend layout of a memory control logic unit according to the present disclosure;
FIG. 4 is a schematic diagram of a memory-side buffer output module according to the present disclosure;
FIG. 5 is a schematic diagram of a data parallel-to-serial conversion decoding circuit according to the present disclosure;
FIG. 6 is a schematic diagram of a data parallel-to-serial conversion decoding circuit according to the present disclosure;
FIG. 7 is a schematic diagram of an interface-side buffer output module according to the present disclosure; and
FIG. 8 is a schematic diagram of a memory read/write clock gate control circuit according to the present disclosure.

### DETAIL DESCRIPTION OF EMBODIMENTS

The implementations of the present disclosure will be described in detail below with reference to the drawings.

It should be noted that the terms "first", "second" and the like in the description, claims and drawings of the present disclosure are used for distinguishing between similar objects, but not necessarily for describing a particular order or a chronological order.

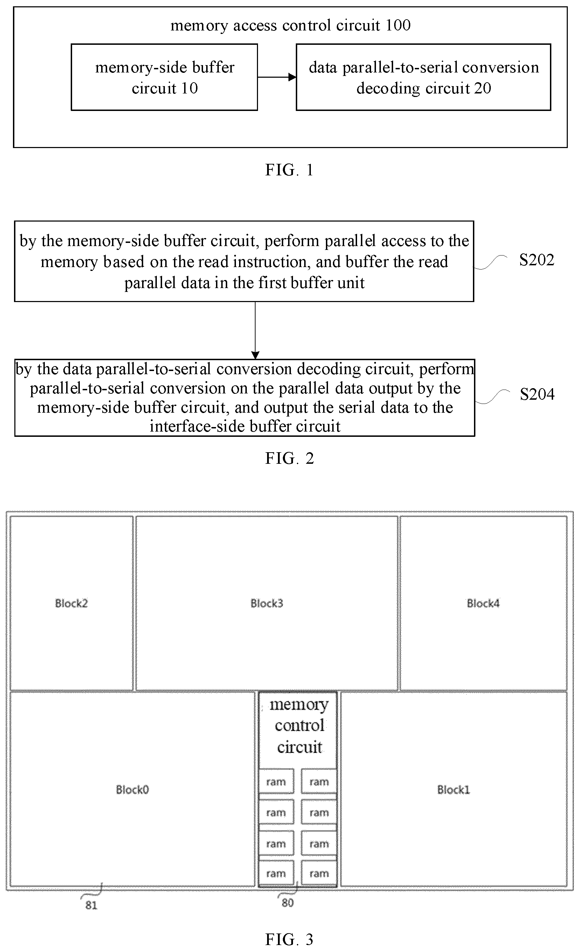

In view of the requirements of increasing read/write frequency and reducing chip power consumption when a plurality of devices in an SOC perform read/write access to a memory through an Advanced Extensible Interface (AXI) bus, an implementation of the present disclosure provides a memory access control circuit. FIG. 1 is a block diagram of a memory access control circuit according to the present disclosure. As shown in FIG. 1, the memory access control circuit 100 includes: a memory-side buffer circuit 10 and a data parallel-to-serial conversion decoding circuit 20.

The memory-side buffer circuit 10 is configured to perform parallel access to a memory based on a read instruction, and buffer read parallel data in a first buffer unit.

An input terminal of the data parallel-to-serial conversion decoding circuit 20 is connected to an output terminal of the memory-side buffer circuit 10, and the data parallel-to-serial conversion decoding circuit 20 performs parallel-to-serial conversion on the parallel data output by the memory-side buffer circuit 10 and outputs serial data to an interface-side buffer circuit.

According to the above implementation of the present disclosure, since the parallel data read from the memory is first stored in the buffer unit and then converted into the serial data with the data parallel-to-serial conversion decoding circuit, both data reading efficiency and an operating frequency of a chip can be ensured.

In an exemplary implementation, the data parallel-to-serial conversion decoding circuit 20 includes: a decoding logic unit, which is configured to decode an access index to generate and output selection control signals for a plurality of first data selectors, the access index being a plurality of bits determined based on a read address and a read length in the read instruction; and the plurality of first data selectors that are cascaded in sequence, an output terminal of the first data selector in a previous stage being connected to one input terminal of the first data selector in a following stage, other input terminals of the plurality of first data selectors being connected in parallel to the output terminals of the memory-side buffer circuit 10, and control terminals of the plurality of first data selectors being respectively connected to corresponding selection-control-signal output terminals of the decoding logic unit.

In an exemplary implementation, the memory access control circuit 100 further includes: one stage of register or multiple stages of registers disposed between at least one pair of adjacent first data selectors, and one stage of register or multiple stages of registers disposed at the control terminal of each of other first data selectors following the first data selectors provided with the one stage of register or the multiple stages of registers. In the present implementation, by disposing the one stage of register or the multiple stages of registers between the at least one pair of adjacent first data selectors, an operating frequency of the circuit can be improved, and a compact logic structure can be realized.

In an exemplary implementation, the memory-side buffer circuit 10 includes: a plurality of second data selectors, each input terminal of the plurality of second data selectors being respectively connected to an output terminal of a respective one memory cell, and each second data selector being configured to select data from one of a plurality of memory cells connected thereto for output; a plurality of first buffer units, input terminals of the plurality of first buffer units being connected to output terminals of the plurality of second data selectors and configured to buffer data output from the second data selectors; and a plurality of third data selectors, each input terminal of the plurality of third data selectors being respectively connected to an output terminal of a respective one first buffer unit, and each third data selector being configured to select data from one of a plurality of first buffer units connected thereto for output.

In an exemplary implementation, the memory access control circuit 100 further includes: a read/write clock gate control circuit, which is connected to the memory-side buffer circuit 10, and is configured to transmit a first operating clock, a write enable control signal, and a read enable control signal to the memory-side buffer circuit 10.

In an exemplary implementation, the read/write clock gate control circuit includes: a first register, two input terminals of the first register being respectively connected to a second operating clock and the write enable control signal; a second register, two input terminals of the second register being respectively connected to the second operating clock and the read enable control signal; an OR gate logic unit, input terminals of the OR gate logic unit being respectively connected to an output terminal of the first register, an output terminal of the second register, the write enable control signal, and the read enable control signal; and a divide-by-2 frequency divider, input terminals of the divide-by-2 frequency divider being respectively connected to an output terminal of the OR gate logic unit and the second operating clock, and an output terminal of the divide-by-2 frequency divider being connected to the memory-side buffer circuit 10. In the present implementation, the first operating clock is generated when the read enable control signal and/or the write enable signal are/is valid, and a frequency of the first operating clock is one-half of a frequency of the second operating clock, which can effectively reduce invalid inversion of a memory read/write clock and also reduce the power consumption of the chip.

In an exemplary implementation, the memory access control circuit 100 further includes: an interface-side buffer output circuit, which is configured to buffer the serial data read from the data parallel-to-serial conversion decoding circuit 20 and output the serial data to an external bus.

In an exemplary implementation, the interface-side buffer output circuit includes: a buffer circuit and a first-in first-out memory connected to an output terminal of the buffer circuit.

The present disclosure further provides a memory access control method based on the memory access control circuit provided in the above implementations. FIG. 2 is a flowchart illustrating a memory access control method according to the present disclosure. As shown in FIG. 2, the memory access control method includes the following operations S202 and S204.

At operation S202, the memory-side buffer circuit performs parallel access to the memory based on the read instruction, and buffers the read parallel data in the first buffer unit.

At operation S204, the data parallel-to-serial conversion decoding circuit performs parallel-to-serial conversion on the parallel data output by the memory-side buffer circuit, and outputs the serial data to the interface-side buffer circuit.

In an exemplary implementation, the memory access control method further includes: by the interface-side buffer output circuit, buffering the serial data output from the data parallel-to-serial conversion decoding circuit, and outputting the serial data to an external bus.

According to the present disclosure, since the parallel data read from the memory is first stored in the buffer unit and then converted into the serial data with the data parallel-to-serial conversion decoding circuit, both data reading efficiency and an operating frequency of a chip can be ensured, so that the problem of low operating frequency and high power consumption of the chip in the memory access method in the related technology can be solved, the operating frequency of the chip is improved, and the power consumption of the chip is reduced.

Through the above description of the implementations, those of ordinary skill in the art can understand clearly that the method according to the above embodiments may be implemented by software together with a necessary general-purpose hardware platform, and may also be implemented by hardware. Based on such understanding, the technical solutions of the present disclosure may be implemented in the form of a software product, which is stored in a storage medium (such as a Read-Only Memory (ROM)/Random Access Memory (RAM), a magnetic disk and an optical disc) and includes several instructions to enable a terminal device (which may be a mobile phone, a computer, a server or a network device) to execute the method described in each implementation of the present disclosure.

It should be noted that each of the above modules may be implemented by software or hardware, and when implemented by hardware, the modules may be implemented in a following way: all the modules are located in a same processor; or the modules are randomly combined and located in different processors. However, the implementation of the above modules is not limited thereto.

In order to facilitate an understanding of the technical solutions provided in the present disclosure, a detailed description is given below with reference to implementations of exemplary scenarios.

The present disclosure discloses a memory access method and circuit with high chip frequency and low power consumption, which can meet the requirements of increasing read/write frequency and reducing chip power consumption when a plurality of devices in an SOC perform read/write access to a memory through an AXI bus in the field of design of digital chips, especially in a case where a backend layout such as a Floorplan of a chip is limited, that is, the requirements of improving chip frequency and reducing chip power consumption can be met in a case of a narrow and long Floorplan. FIG. 3 is a schematic diagram of a backend layout of a memory control logic unit according to the present disclosure, 80 in FIG. 3 refers to an application of the memory control circuit of the present disclosure in a backend layout of a real chip; and Block0 81 and Block 1, Block 2, Block 3, and Block 4 refer to a Floorplan of other circuit logic in the real chip. In an implementation of the present disclosure, the memory control circuit 80 is a long and narrow Floorplan structure, many memories (e.g., RAMs) are provided, and the memory access control circuit provided in the implementations of the present disclosure can effectively improve a dominant frequency of the chip and reduce power consumption of the chip in a case where the backend layout such as the Floorplan of the chip is limited. By applying the memory access control circuit of the present disclosure, especially the parallel-to-serial conversion decoding circuit therein, to the long and narrow Floorplan structure, a register can be inserted between any decoding points, and data can be read from the RAMs hierarchically. The application to the long and narrow Floorplan structure can be easily implemented at a back end, and can significantly increase operating frequency of the chip.

Illustratively, the circuit according to the implementations of the present disclosure performs parallel access to a plurality of physical memory entities based on an AXI read/write instruction, stores access data in the buffer structure, and serially outputs the data based on the access index through the parallel-to-serial conversion decoding circuit provided in the implementations of the present disclosure. In some implementations of the present disclosure, the parallel-to-serial conversion decoding circuit may have a register inserted in any stage of decoding point and read data from the RAM hierarchically, and is particularly applicable to a long and narrow Floorplan memory structure for improving the operating frequency of the chip. Meanwhile, some implementations of the present disclosure further provide an efficient memory read/write clock gate control circuit, which can effectively reduce invalid inversion of a clock at a memory port and reduce the power consumption of the chip.

The apparatus and method of the present disclosure are further described below with reference to the drawings and exemplary implementations.

The present disclosure provides a memory access circuit with high chip frequency and low power consumption, and the circuit includes four parts: a memory-side buffer output module, a data parallel-to-serial conversion decoding circuit for improving the operating frequency of the chip, an interface-side buffer output module, and a memory read/write clock gate control circuit for reducing the power consumption of the chip.

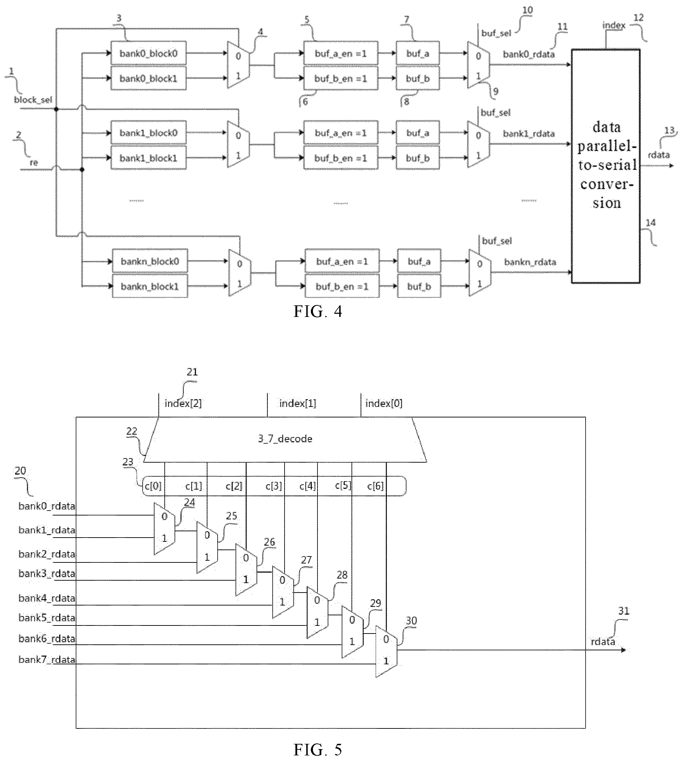

FIG. 4 is a schematic diagram of a memory-side buffer output module according to the present disclosure. Illustratively, the following five operations are performed in the present implementation based on the memory-side buffer output module, but the present disclosure is not limited thereto.

At a first operation, a read enable signal re 2 for physical entities 3 (i.e., physical blocks or physical banks) of memories is generated based on a read instruction of the AXI bus, a signal block_sel 1 is generated based on a read address of the read instruction, the read enable signal re may act on the physical blocks and the physical banks of all the memories to read data from all the physical entities (i.e., the physical blocks or the physical banks) of all the memories in parallel at one time based on the read enable signal re.

At a second operation, each block is subjected to selection (mux) based on the signal block_sel 1, and a mux structure 4 is a 2-1 mux logic unit. The mux logic unit is related to the number of blocks, and if there are a plurality of blocks, e.g., 4 blocks, the mux structure adopts a 4-1 mux logic unit.

At a third operation, based on a write enable signal buf_a_en 5 or a write enable signal buf_b_en 6, the data selected by the mux structure 4 is buffered in a buffer unit buf_a 7 or a buffer unit buf_b 8.

At a fourth operation, a 2-1 mux logic unit 9 is controlled based on a signal buf_sel 10 to select the data buffered in buf_a or buf_b, so as to output buffered data as bank0_rdata 11.

At a fifth operation, a signal index 12 is generated based on the read address and a read length in the AXI read instruction, the parallel data bank0_rdata, bank1_rdata, bank2_rdata ... output from a plurality of buffer units are subjected to parallel-to-serial conversion based on the signal index, and rdata 13 is output to a subsequent logic module through data parallel-to-serial conversion logic 14.

It should be noted that the above operations mainly describe mux selection path data transmission of bank0_block0 and bank0_block1. A real memory may be divided into a plurality of blocks and a plurality of banks. Correspondingly, the mux logic unit 4 may be also adjusted, for example, if there are a plurality of blocks, the mux logic unit 4 needs to be changed from the 2-1 mux logic unit to a the number of blocks-1 mux logic unit. In addition, multiple input data bankn_rdata of the data parallel-to-serial conversion logic unit are related to the number of banks of the real memory, and the input data of the corresponding data parallel-to-serial conversion logic unit need to include bank0_rdata to bankn_rdata. Moreover, a reason for adopting two buffer units (i.e., buf_a and buf_b) in the memory-side buffer output module is to keep a data structure of the memory-side buffer output module consistent with a data structure of the subsequent interface-side buffer output module, that is, the reason for adopting the two buffer units in the memory-side buffer output module is that two buffer units are adopted in the interface-side buffer output module. A reason for adopting the two buffer units in the interface-side buffer output module is to improve data reading efficiency of the AXI bus, that is, the two buffer units are used to balance a chip area and logic complexity, so that, for some AXI read instructions, read data may be directly output from the interface-side buffer output module instead of from the memory, which reduces a path delay of the read data and improves performance of the read data.

FIG. 5 is a schematic diagram of a data parallel-to-serial conversion decoding circuit according to the present disclosure, and the data parallel-to-serial conversion decoding circuit in the present implementation can improve the operating frequency of the chip. Illustratively, the following three operations are performed in the present implementation based on the data parallel-to-serial conversion decoding circuit capable of improving the operating frequency of the chip.

At a first operation, the data parallel-to-serial conversion decoding circuit calculates serial-parallel conversion decoding index 21 corresponding to the read data of each bank of the memory based on the read address araddr and the read length arlen in the read instruction of the AXI bus, index 21 in FIG. 5 is 3 bits, namely index[2], index[1], and index[0]. index is decoded through decoding logic 3_7_decode 22 to obtain 7-bit data 23, namely {c[0], c[1], c[2], c[3], c[4], c[5], c[6]}, a decoding relationship is shown in Table 1: for example, index = 3'b010, after the decoding, c[1]=1, c[2]=0, c[3]=0, c[4]=0, c[5]=0, and c[6]=0. Therefore, a mux logic unit 25 selects data bank2_rdata for output, and thus final decoding output data rdata 31 is bank2_rdata.

**Table 1**

| index | | | 3_7_decode | | | | | | | rdata |
|---|---|---|---|---|---|---|---|---|---|---|
| [2] | [1] | [0] | c[0] | c[1] | c[2] | c[3] | c[4] | c[5] | c[6] | |
| 3'b000 | | | 7'b000_0000 | | | | | | | bank0_rdata |
| 3'b001 | | | 7'b100_0000 | | | | | | | bank1_rdata |
| 3'b010 | | | 7'bx10_0000 | | | | | | | bank2_rdata |
| 3'b011 | | | 7'bxx1_0000 | | | | | | | bank3_rdata |
| 3'b 100 | | | 7'bxxx_1000 | | | | | | | bank4_rdata |
| 3'b101 | | | 7'bxxx_x100 | | | | | | | bank5_rdata |
| 3'b110 | | | 7'bxxx_xx10 | | | | | | | bank6_rdata |
| 3'b111 | | | 7'bxxx_xxx1 | | | | | | | bank7_rdata |

At a second operation, the 7-bit data 23 in FIG. 5 obtained after the decoding serve as enable control signals for seven 2-1 mux logic units, which are numbered 24, 25, 26, 27, 28, 29, and 30 respectively. Input data of the seven 2-1 mux logic units are respectively the data output in parallel from the memory-side buffer output module, bank0_rdata, bank1_rdata ... bank7_rdata 20 in FIG. 5 are input as parallel data to the seven 2-1 mux logic units, the 2-1 mux logic units convert the parallel data into serial data based on the decoding result of index 21 and output the serial data at one time, and the output data is rdata 31.

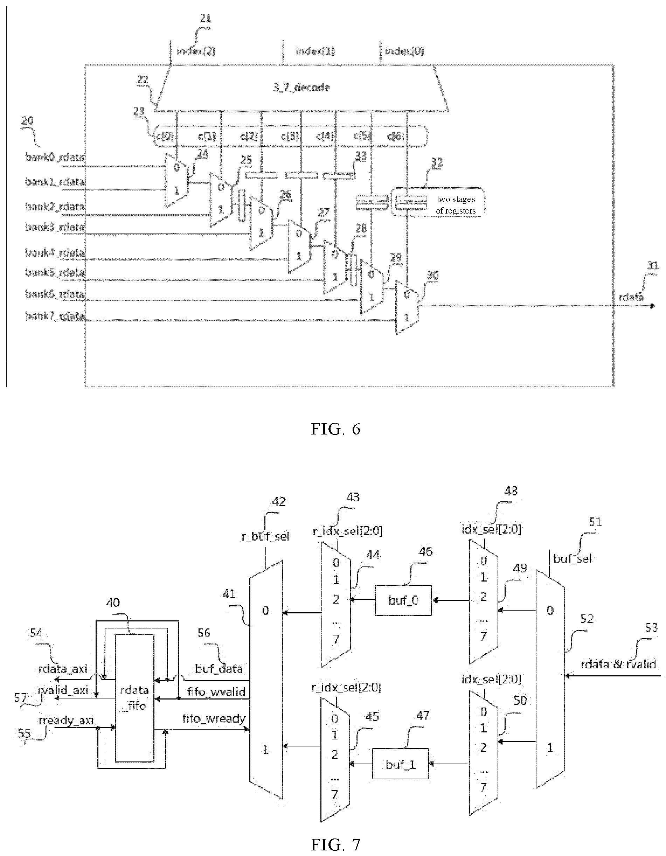

At a third operation, in the data parallel-to-serial conversion decoding circuit according to the present implementation, registers of any number of stages may be inserted between two 2-1 mux logic units for improving operating frequency of the circuit and facilitating physical implementation of the chip. As shown in FIG. 6, one stage of register is inserted between a mux logic unit 25 and a mux logic unit 26, and one stage of register is inserted between a mux logic unit 28 and a mux logic unit 29. It should be noted that, if one stage of register is inserted between two mux logic units, one stage of register needs to be inserted for each of selection control signals c[*] of all the mux logic units following the mux logic units. As shown in FIG. 6, since one stage of register is inserted between the mux logic unit 25 and the mux logic unit 26, one stage of register, such as a register 33 or a register 32, needs to be inserted for each of the control signals c[2], c[3], c[4], c[5], and c[6]. Since one stage of register is inserted between the mux logic unit 28 and the mux logic unit 29, one stage of register is further inserted for each of the control signals c[5] and c[6], so that two stages of registers, such as the registers 32, are inserted for each of the control signals c[5] and c[6]. Accordingly, if n stages of registers are inserted between two mux logic units, n stages of registers need to be inserted for each of the selection control signals c[*] of all the mux logic units following the mux logic units.

It should be noted that FIG. 5 and FIG. 6 illustrate the same example, that is, index is 3 bits, and there are eight corresponding input parallel data. If the number of the physical banks of the memory is increased and there are sixteen input parallel data, the corresponding index is 4 bits. At this time, the decoding module may generate sixteen mux logic unit control signals through decoding of 4-bit index, and so on. The number of the input parallel data is not necessarily a power of 2, and may be any number. For example, there are five input parallel data, namely bank0_rdata, bank1_rdata, bank2_rdata, bank3_rdata, and bank4_rdata, in which case index still needs to be 3 bits, the mux logic unit control signals c[4], c[5], and c[6] obtained after the decoding are constantly 0, that is, the mux logic units 28, 29, and 30 are equivalent to a buffer. Since c[4], c[5], and c[6] are constantly 0 at this time, bank5_rdata, bank6_rdata, and bank7_rdata may be any values.

In summary, the data parallel-to-serial conversion decoding circuit capable of improving the operating frequency of the chip according to the implementation of the present disclosure can support decoding output of any number of parallel data read from the memory, and can support insertion of any number of registers between any two mux logic units. The insertion of the registers can effectively improve the operating frequency of the chip and facilitate backend physical implementation.

FIG. 7 is a schematic diagram of an interface-side buffer output module according to the present disclosure. The following three operations are performed in the present implementation based on the interface -side buffer output module.

At a first operation, the interface-side buffer output module is configured to buffer the serial data rdata 53 read from the memory-side buffer output module, read data of an AXI reverse channel is output to an external bus through the interface-side buffer output module based on the AXI read instruction, rvalid is a data valid indication signal. rdata 53 passes through a mux logic unit 52, the mux logic unit 52 is controlled by a signal buf_sel 51, rdata is buffered in buf_0 46 in a case where buf_sel is 0, and rdata is buffered in buf_1 47 in a case where buf_sel is 1. A selection logic unit 49 stores rdata in buf_0 based on a signal idx_sel 48, and a selection logic unit 50 stores rdata in buf_1 based on the signal idx_sel. Each of the idx_sel selection logic units 49 and 50 has eight idx (0, 1 ... 7), that is, eight rdata may be buffered in each of buf_0 and buf_1.

At a second operation, the data in buf_0 and buf_1 are output to an AXI bus read data channel. For outputting the data, r_idx_sel 43 and r_buf_sel 42 are first calculated based on araddr and arlen of an AXI read instruction channel. r_idx_sel is configured to control to select an index of the data read from buf 44 or buf 45, and r_buf_sel is configured to control a 2-1 circuit 41 to select the data from buf_0 or buf_1 for output. Adopting the two buffer units has a following advantage: the two buffer units can buffer more data read from the memory, and if data to be read based on a subsequent read instruction is stored in the buffer units in the interface-side buffer output module, the data can be directly output from the buffer units to the bus, instead of being read from the memory after sending the read instruction, so that the read data can be output to the external bus quickly, a delay of reading data can be reduced, and performance of reading data can be improved. The number of the buffer units in the interface-side buffer output module may be increased appropriately according to practical applications, for example, more buffer units (buf0, buf1 ... bufn) are adopted, the more the buffer units, the higher the performance of reading data, but the higher the complexity of circuit implementation, and the larger the area of circuit.

At a third operation, the data output from the buffer units in the interface-side buffer output module to the bus needs to pass through rdata_fifo 40. Since the AXI read data channel has a signal rready_axi 55 for backpressure, if the externally input signal rready_axi is 0, it is indicated that returned data rdata_axi 54 cannot be received by an external device. Therefore, the data needs to be stored in rdata_fifo until the handshaking of a signal rvalid_axi 57 and the signal rready_axi is successful, that is, rdata_axi is not read from rdata_fifo until the external device can receive rdata_axi.

It should be noted that rdata_fifo 40 in the present disclosure has a bypass function, that is, when rdata_fifo is empty (that is, when there is no buffer data in rdata_fifo) and the signal rready_axi 55 is high, it is indicated that the external device can receive the read data, at this time, rdata_fifo may perform the bypass function, that is, buf_data 56 is directly output without passing through rdata_fifo. Merely in a case where buf_data 56 needs to be stored in rdata_fifo due to external backpressure, the data needs to be output from rdata_fifo. When there is data in rdata_fifo, the data must be output through rdata_fifo and is not allowed to be output with the bypass function, otherwise a data sequence error may be caused. When the data in rdata_fifo is all read, rready_axi is always high, rdata_fifo enters a bypass state, and data can be directly output without passing through rdata_fifo. It should be further noted that another reason for using rdata_fifo is to simplify control logic of rready_axi 55 under backpressure. If rdata_fifo is not used, the backpressure by the external rready_axi needs to be simultaneously applied to a plurality of buffer units such as buf_0 and buf_1, which may increase complexity of the control logic.

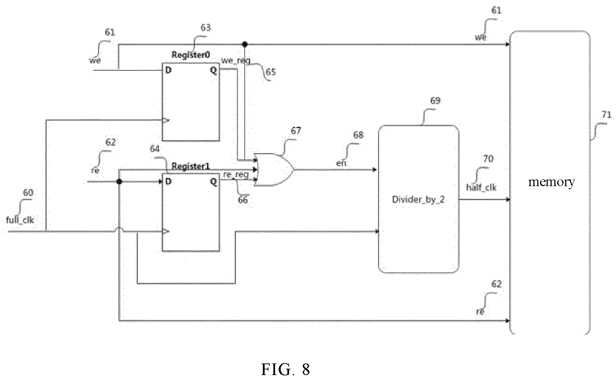

FIG. 8 is a schematic diagram of a memory read/write clock gate control circuit according to the present disclosure, which is beneficial to reduction of the power consumption of the chip. The following two operations may be performed in the present implementation based on the memory read/write clock gate control circuit.

At a first operation, as shown in FIG. 8, full_clk 60 is an operating clock of memory control logic, and we 61 is a memory write enable signal generated under full_clk. re 62 is a memory read enable signal generated under full_clk, Register0 63 is a sampling register for the signal we, and output of Register0 63 is we_reg 65, i.e., one-stage register output of the write enable signal. Register1 64 is a sampling register for the signal re, and output of Register1 64 is re_reg 66, i.e., one-stage register output of the read enable signal.

At a second operation, the four signals we, we_reg, re, and re_reg pass through an OR logic gate 67, the OR logic gate 67 outputs a signal en 68, the signal en and full_clk 60 are input to a divide-by-2 frequency divider unit Divider_by_2, the divide-by-2 frequency divider unit performs frequency halving on the clock full_clk based on the enable signal en to output a clock half_clk 70, a clock frequency of half_clk is one-half of a clock frequency of full_clk, and dynamic inversion of half_clk occurs merely when en is valid. we 61, re 62, and half_clk 70 are input to memory 71. we and re are taken as a write enable control signal and a read enable control signal for memory, and half_clk is taken as an operating clock of memory.

It should be noted that the operating clock half_clk of memory is a clock generated by dynamic gate control under the condition that the read and write enable signals are valid, and the frequency of half_clk is one-half of the frequency of the operating clock. Therefore, the memory read/write clock gate control circuit structure provided in the implementation of the present disclosure can effectively reduce the invalid inversion of the memory read/write clock and reduce the power consumption of the chip.

The present disclosure further provides a computer-readable storage medium having a computer program stored therein, and the computer program is configured to perform, when being run, the operations in any of the above method implementations.

In an exemplary implementation, the computer-readable storage medium may include, but is not limited to, various media capable of storing the computer program, such as a Universal Serial Bus Flash Disk (a USB flash disk), an ROM, an RAM, a mobile hard disk, a magnetic disk and an optical disc

The present disclosure further provides an electronic device, including a storage device and a processor, the storage device stores a computer program, and the processor is configured to run the computer program to perform the operations in any of the above method implementations.

In an exemplary implementation, the electronic device may further include a transmission device connected to the processor, and an input/output device connected to the processor.

Reference may be made to the examples described in the above implementations and exemplary implementations for examples of the present implementation, and thus the examples of the present implementation are not described in detail here.

Apparently, it should be understood by those of ordinary skill in the art that all the modules or operations of the present disclosure described above may be implemented by a general-purpose computing device, may be integrated in a single computing device or distributed on a network composed of a plurality of computing devices, and may be implemented by program codes executable by a computing device, such that the modules or operations can be stored in a storage device and executed by a computing device. In some cases, the operations illustrated or described may be performed in an order different from that described herein. The modules or operations may be separately made into integrated circuit modules, or some of the modules or operations may be made into a single integrated circuit module. Thus, the present disclosure is not limited to any specific combination of hardware and software.

The description above is merely of the exemplary implementations of the present disclosure, but is not intended to limit the present disclosure. Various modifications and changes may be made to the present disclosure by those of ordinary skill in the art. Any modification, equivalent replacement and improvement made within the principle of the present disclosure should be included in the protection scope of the present disclosure.

## Claims

1. A memory access control circuit, comprising:
a memory-side buffer circuit, which is configured to perform parallel access to a memory based on a read instruction, and buffer read parallel data in a first buffer unit; and
a data parallel-to-serial conversion decoding circuit, which has an input terminal connected to an output terminal of the memory-side buffer circuit, and is configured to perform parallel-to-serial conversion on the parallel data output by the memory-side buffer circuit and output serial data to an interface-side buffer circuit.

2. The circuit of claim 1, wherein the data parallel-to-serial conversion decoding circuit comprises:
a decoding logic unit, which is configured to decode an access index to generate and output selection control signals for a plurality of first data selectors, wherein the access index is a plurality of bits determined based on a read address and a read length in the read instruction; and
the plurality of first data selectors that are cascaded in sequence, an output terminal of a first data selector in a previous stage being connected to one input terminal of a first data selector in a following stage, other input terminals of the plurality of first data selectors being connected in parallel to output terminals of the memory-side buffer circuit, and control terminals of the plurality of first data selectors being respectively connected to corresponding selection-control-signal output terminals of the decoding logic unit.

3. The circuit of claim 2, wherein one stage of register or multiple stages of registers are disposed between at least one pair of adjacent first data selectors, and one stage of register or multiple stages of registers are disposed at a control terminal of each of other first data selectors following the first data selectors provided with the one stage of register or the multiple stages of registers.

4. The circuit of claim 1, wherein the memory-side buffer circuit comprises:
a plurality of second data selectors, each input terminal of the plurality of second data selectors being respectively connected to an output terminal of a respective one memory cell, and each second data selector being configured to select data from one of a plurality of memory cells connected to the second data selector for output;
a plurality of first buffer units, input terminals of the plurality of first buffer units being connected to output terminals of the plurality of second data selectors and configured to buffer data output from the plurality of second data selectors; and
a plurality of third data selectors, each input terminal of the plurality of third data selectors being respectively connected to an output terminal of a respective one first buffer unit, and each third data selector being configured to select data from one of a plurality of first buffer units connected to the third data selector for output.

5. The circuit of claim 1, further comprising:
a read/write clock gate control circuit, which is connected to the memory-side buffer circuit, and is configured to transmit a first operating clock, a write enable control signal, and a read enable control signal to the memory-side buffer circuit.

6. The circuit of claim 5, wherein the read/write clock gate control circuit comprises:
a first register, two input terminals of the first register being respectively connected to a second operating clock and the write enable control signal;
a second register, two input terminals of the second register being respectively connected to the second operating clock and the read enable control signal;
an OR gate logic unit, input terminals of the OR gate logic unit being respectively connected to an output terminal of the first register, an output terminal of the second register, the write enable control signal, and the read enable control signal; and
a divide-by-2 frequency divider, input terminals of the divide-by-2 frequency divider being respectively connected to an output terminal of the OR gate logic unit and the second operating clock, and an output terminal of the divide-by-2 frequency divider being connected to the memory-side buffer circuit.

7. The circuit of claim 1, further comprising:
an interface-side buffer output circuit, which is configured to buffer the serial data read from the data parallel-to-serial conversion decoding circuit and output the serial data to an external bus.

8. The circuit of claim 7, wherein the interface-side buffer output circuit comprises: a buffer circuit and a first-in first-out memory connected to an output terminal of the buffer circuit.

9. A memory access control method applied to the memory access control circuit of any one of claims 1 to 8, comprising:
by the memory-side buffer circuit, performing parallel access to the memory based on the read instruction, and buffering the read parallel data in the first buffer unit; and
by the data parallel-to-serial conversion decoding circuit, performing parallel-to-serial conversion on the parallel data output by the memory-side buffer circuit, and outputting the serial data to the interface-side buffer circuit.

10. The method of claim 9, further comprising:
by the interface-side buffer output circuit, buffering the serial data output from the data parallel-to-serial conversion decoding circuit, and outputting the serial data to an external bus.

11. A computer-readable storage medium having stored therein a computer program which, when executed by a processor, causes the processor to implement the method of claim 9 or 10.

12. An electronic device, comprising a storage device, a processor, and a computer program, which is stored on the storage device and executable on the processor, wherein the processor implements the method of claim 9 or 10 when executing the computer program.
